# EUROPÄISCHE PATENTANMELDUNG

(11) **EP 1 033 627 A2**
(43) Veröffentlichungstag der Anmeldung: **06.09.2000**
(21) Anmeldenummer: 00104704.2
(22) Anmeldetag: 03.03.2000
(51) Int. Cl.: G03F 7/42, B41C 1/14

(54) **Verfahren und Vorrrichtung zum Wiederverwerten einer Siebdruckschablone**

(30) Priorität: 04.03.1999 DE 19909520
(71) Anmelder: MHM Sales & Services, Spartanburg S.C. 29303 (US)
(72) Erfinder: Lintner, Alexander, 6330 Kufstein (AT)
(74) Vertreter: Wunderlich, Rainer, Dipl.-Ing.

(57) **Zusammenfassung**

Die Erfindung betrifft ein Verfahren und eine Vorrichtung zum Wiederverwerten von Siebdruckschablonen, auf welche auf einer Fläche mittels einer Lackschicht ein Druckmuster aufgebracht ist. Die Lackschicht wird mittels eines Dauerstrichlasers entfernt, der einen permanenten Laserstrahl erzeugt. Dabei überstreicht der Laserstrahl die gesamte mit dem Druckmuster versehene Fläche zeilenartig. Die Leistung des Laserstrahls ist so eingestellt, daß an beschichteten Bereichen der Fläche die Lackschicht abgebrannt und/oder verdampft wird und daß an unbeschichteten Bereichen der Fläche der Laserstrahl ohne wesentliche Beeinflussung der Siebdruckschablone reflektiert und/oder absorbiert wird. Anschließend kann eine neue Lackschicht und ein neues Druckmuster aufgebracht werden.

## Beschreibung

Die Erfindung betrifft ein Verfahren zum Wiederverwerten einer Siebdruckschablone gemäß dem Oberbegriff des Anspruchs 1 und eine Vorrichtung zur Durchführung des Verfahrens.

Bei diesem Verfahren zum Wiederverwerten einer Siebdruckschablone, auf welcher auf einer Fläche mittels einer Lackschicht ein Druckmuster augebracht ist, wobei die Lackschicht an vorgegebenen Bereichen der Fläche angeordnet ist, während andere Bereiche der Fläche entsprechend dem Druckmuster unbeschichtet sind, wird die Lackschicht von der Fläche der Siebdruckschablone entfernt und anschliessend wird eine neue Lackschicht mit einem Druckmuster aufgebracht.

Siebdruckschablonen umfassen üblicherweise eine perforierte Metallfolie, welche abhängig vom Druckverfahren zu einer Platten- oder Zylinderform aufgespannt sein kann. Die Perforationen der Siebdruckschablone, welche beispielsweise zwischen 100 mesh und 250 mesh betragen können, dienen zum Durchtritt und Übertragen einer Druckfarbe auf ein zu bedruckendes Substrat. Zum Drucken eines gewünschten Musters werden die Perforationen in bestimmten Bereichen der Siebdruckschablone mit einer Lackschicht verschlossen, so daß entsprechend dem gewünschten Muster die Druckfarbe nur durch die unverschlossenen Perforationen übertragen wird.

Mit einer einmal beschichteten Siebdruckschablone kann daher nur ein Muster gedruckt werden. Bei einem geänderten Druckmuster ist eine neue Siebdruckschablone mit einer anderen Lackbeschichtung notwendig.

Zum Wiederverwerten gebrauchter Siebdruckschablonen wurde versucht, die Lackschicht durch Lösungsmittel von der Siebdruckschablone zu entfernen. Das Arbeiten mit chemischen Lösungsmitteln erfordert jedoch aufgrund bestehender Arbeits- und Umweltschutzvorschriften aufwendige Einrichtungen. Weiter ist die Entsorgung gebrauchter, mit Lack verunreinigter Lösungsmittel sehr kostenaufwendig. Das Entfernen einer Lackschicht nach diesem Verfahren und eine anschliessende Neubeschichtung der Siebdruckschablone ist daher nur in Ausnahmefällen wirtschaftlich. Üblicherweise werden Siebdruckschablonen vielmehr als Ein-Weg-Produkt angesehen, die bei einer Änderung des Druckmusters entsorgt werden.

Der Erfindung liegt die **Aufgabe** zugrunde, ein Verfahren und eine Vorrichtung anzugeben, mit denen Siebdruckschablonen besonders wirtschaftlich aufbereitet und wiederverwendet werden können.

Die Aufgabe wird zum einen durch ein Verfahren mit den kennzeichnenden Merkmalen des Anspruchs 1 gelöst. Erfindungsgemäß ist vorgesehen, daß zum Entfernen der Lackschicht mindestens ein Dauerstrichlaser verwendet wird, der einen permanenten Laserstrahl erzeugt, daß die gesamte, mit dem Druckmuster versehene Fläche von dem Laserstrahl zeilenartig überstrichen wird und daß die Leistung des Laserstrahls eingestellt wird, so daß an beschichteten Bereichen der Fläche die Lackschicht abgebrannt und/oder verdampft wird und daß an unbeschichteten Bereichen der Fläche der Laserstrahl ohne wesentliche Beeinflussung der Siebdruckschablone reflektiert und/oder absorbiert wird.

Mit dem erfindungsgemäßen Verfahren kann eine bereichsweise aufgebrachte Lackschicht von der Oberfläche einer Siebdruckschablone gründlich und zugleich wirtschaftlich entfernt werden. Zum Abbrennen der Lackschicht wird ein einfacher Dauerstrichlaser benötigt, der einen kontinuierlichen Laserstrahl erzeugt. Im Gegensatz zu sogenannten getakteten Hochleistungslasern, welche bei der Druckmustererstellung verwendet werden können und dabei einen Investitionsaufwand weit über DM 1.000.000,-- darstellen, sind einfache Dauerstrichlaser für einen Betrag von unter DM 40.000,-- auf dem Markt erhältlich. Da keinerlei chemische Mittel verwendet werden müssen, ist das Entfernen der Lackschicht unproblematisch durchführbar. Zudem können aufwendige Vorkehrungen für den Arbeits- und Umweltschutz entfallen.

Nach dem Entfernen der Lackschicht liegt ein nahezu neuwertiger Druckschablonenrohling vor. Dieser kann erneut mit einem Druckmuster nach einem beliebigen Verfahren versehen werden, etwa einem Fotolackverfahren oder einem EngraverVerfahren. Bei dem letztgenannten Verfahren wird der Rohling insgesamt mit Lack beschichtet, welcher dann an gewünschten Bereichen mittels eines vorgenannten getakteten Hochleistungslaser entfernt wird.

Grundsätzlich können bei dem erfindungsgemäßen Verfahren mit der Lackechicht auch verbliebene Druckfarbreste entfernt werden. Für eine effiziente und energieschonende Entfernung der Lackschicht ist es jedoch vorteilhaft, daß die Siebdruckschablone vor dem Entfernen der Lackschicht vorbehandelt wird und insbesondere von Resten einer Druckfarbe unter Beibehaltung der Lackschicht gereinigt wird. Diese Reinigung kann beispielsweise durch ein Abspritzen der Siebdruckschablone mit Wasser erfolgen. Es kann auch eine Aufrauhung oder sonstige Veränderung der Oberflächenstruktur der Lackachicht erfolgen, so daß die Reflexion an der Lackschicht vermindert wird.

Eine bevorzugte Weiterbildung der Erfindung besteht darin, daß zum Überstreichen der Fläche mit dem Laserstrahl eine Relativbewegung zwischen dem Laser und der Siebdruckschablone mit einer Vorschubgeschwindigkeit durchgeführt wird, welche beispielsweise im Bereich von 5 m/s bei einem 300 W-Laser betragen kann. Die Vorschubgeschwindigkeit ist dabei auf die Leistung des Lasers so abgestimmt, daß einerseits ein zuverlässiges Verbrennen oder Verdampfen der Lackschicht auch aus den Perforationen sichergestellt ist und andererseits keine Beschädigung des Rohlings der Siebdruckschablone entsteht, wenn der Laserstrahl einen unbeschichteten Bereich der Siebdruckschablone überstreicht.

Weiter ist es nach der Erfindung vorgesehen, daß bei Verwendung einer zylindrischen Siebdruckschablone diese zentrisch zu ihrer Zylinderachse eingespannt und um die Zylinderachse in Rotation versetzt wird, daß der Laserstrahl im wesentlichen radial zur Zylinderachse auf die Siebdruckschablone ausgerichtet und aufgebracht wird und daß eine gleichmäßige Relativbewegung parallel zur Zylinderachse zwischen dem Laser und der rotierenden Siebdruckschablone durchgeführt wird. Mit diesem Verfahren können für Rotationssiebdruckmaschinen eingesetzte Druckschabionen unter Beibehaltung ihrer zylindrischen Form aufbereitet werden. Die Rotation der Siebdruckschablone stellt dabei die Vorschubgeschwindigkeit des Laserstrahls in Umfangsrichtung dar. Der Vorschub parallel zur Zylinderachse führt zu einem spiral- oder helixförmigen Überstreichungsweg des Lasers an der Siebdruckschablone. Abhängig von der Größe der Auftrefffläche des Laserstrahls und somit von der Breite einer Überstreichungszeile ist der Vorschub in axialer Richtung so einzustellen, daß bei einer Umdrehung der Siebdruckschablone der Vorschub kleiner oder höchstens gleich der Breite der Überstreichungszeile ist.

Bei einer alternativen Ausführungsform der Erfindung ist bevorzugt, daß bei Verwendung einer plattenförmigen Siebdruckschablone eine reversierende Linearbewegung relativ zwischen dem Laser und der Siebdruckschablone durchgeführt wird. Die Druckschablonenplatte, welche eine ebene oder gewölbte Form aufweisen kann, wird von dem Laserstrahl von einer Seite zu der gegenüberliegenden Seite überstrichen, wobei an den Randkanten jeweils eine Bewegungsumkehr um 180° erfolgt. Bei der Bewegungsumkehr an den Randkanten der Siebdruckschablone wird längs der Randkanten ein Vorschub durchgeführt, welcher kleiner oder höchstens gleich der Breite einer Überstreichungszeile des Laserstrahls ist.

Für ein schnelles Entfernen der Lackschicht ist es vorteilhaft, daß eine Brennpunktsfläche des Laserstrahls auf der Siebdruckschablone möglichst groß eingestellt wird, insbesondere mit einem Durchmesser zwischen 0,1 mm und 5 mm, vorzugsweise 0,5 mm. Eine besonders gutes Entschichten wird ermöglicht, wenn ein blauer Lack verwendet wird und die Siebdruckschablone aus einem Nickelwerkstoffbesteht.

Der zweite Teil der Aufgabe wird durch eine Vorrichtung gelöst, welche dadurch gekennzeichnet ist, daß ein Dauerstrichlaser vorgesehen ist, welcher einen permaneten Laserstrahl erzeugt, daß eine Aufnahmeeinrichtung zum Einspannen einer Siebdruckschablone angeordnet ist, daß zum Überstreichen der Fläche mit dem Laserstrahl eine Ablenkeinrichtung am Laser oder eine Bewegungseinrichtung für eine Relativbewegung zwischen dem Laser und der Aufnahmeeinrichtung angeordnet ist und daß eine Steuereinrichtung zum Steuern der Ablenkeinrichtung oder Bewegungseinrichtung vorgesehen ist, so daß der Laserstrahl eine mit der Lackschicht versehene Fläche der Siebdruckschablone zeilenartig überstreicht. Als Ablenkeinrichtung kann ein verstellbarer Spiegel eingesetzt werden. Mit dieser Vorrichtung kann das vorausgehend beschriebene Verfahren und die damit verbundenen Vorteile durchgeführt bzw. erreicht werden. Die Ablenkeinrichtung kann auch ein flexibles Lichtleitkabel sein, dessen eines Ende auf einem verfahrbaren Schlitten und das andere Ende an einem stationären Laser angeordnet ist.

Eine zuverlässige und zugleich kostengünstige Ausführungsform der Erfindung besteht darin, daß der Dauerstrichlaser ein CO₂-Laser ist. Insbesondere kann ein CO₂-Laser des sogenannten "sealed"-Typs eingesetzt werden. Eine gute Effizienz wird bei einer Wellenlänge von 1 nm und größer erreicht.

Bei einer weiteren Ausführungsform ist bevorzugt, daß die Bewegungseinrichtung einen Schlitten aufweist, der in mindestens einer Richtung bewegbar geführt ist, und daß auf dem Schlitten der Laser angebracht ist. Zum Antreiben kann beispielsweise ein Elektromotor mit einem Spindelgetriebe verwendet werden. Eine besonders genaue Linearverschiebung ist durch eine Kugelumlaufspindel erreichbar. Mit dem Laser kann auch eine Düseneinrichtung gekoppelt sein, welche entstehende Verbrennungsgase an der momentanen Bearbeitungsstelle abgesaugt oder abgetragene Partikel davon weg bläst.

Für die Aufbereitung von zylindrischen Siebdruckschablonen ist es erfindungsgemäß vorgesehen, daß die Aufnahmeeinrichtung eine rotierend antreibbare Spindel sowie ein koaxial und versetzt dazu angeordnetes Spannelement aufweist und daß das Spannelement auf einem Reitstock drehbar gelagert ist, der zum Spannen einer zylindrischen Siebdruckschablone axial zur Spindel verschiebbar ist. Ähnlich einer Drehbank kann bei der erfindungsgemäßen Vorrichtung eine zylindrische Siebdruckschablone gehalten und in Rotation versetzt werden, wobei der Laserstrahl einem Drehmeißel vergleichbar axial entlang des Umfangs der rotierenden Siebdruckschablone vorbeigeführt wird. Hierdurch wird auf einfache Weise die Siebdruckschablone spiral- oder helixförmig von der Lackschicht befreit.

Die Erfindung ist dadurch weitergebildet, daß zum Spannen zylindrischer Siebdruckschablonen mit unterschiedlichen Durchmessern die Spindeln und das Spannelement im wesentlichen kegelförmig ausgebildet sind. Die Spindel und das Spannelement weisen dabei eine glatte oder treppenförmige Kegelform auf, wobei alle üblichen Durchmesser von zylindrischen Siebdruckschablonen abgedeckt sind. Die Anpassung an den Zylinderdurchmesser erfolgt dabei durch eine axiale Verschiebung des Reitstocks mit dem kegelförmigen Spannelement auf die Spindel zu oder von der Spindel weg.

## Patentansprüche

1. Verfahren zum Wiederverwerten einer Siebdruckschablone, bei welcher an einer Fläche mittels einer Lackschicht ein Druckmuster aufgebracht ist, wobei die Lackschicht an vorgegebenen Bereichen der Fläche angeordnet ist, während andere Bereiche der Fläche entsprechend dem Druckmuster unbeschichtet sind, bei dem
- die Lackschicht von der Fläche der Siebdruckschablone entfernt wird und
- anschließend eine neue Lackschicht mit einem Druckmuster aufgebracht wird,
dadurch **gekennzeichnet,**
- daß zum Entfernen der Lackschicht mindestens ein Dauerstrichlaser verwendet wird, der einen permanenten Laserstrahl erzeugt,
- daß die gesamte, mit dem Druckmuster versehene Fläche von dem Laserstrahl zeilenartig überstrichen wird und
- daß die Leistung des Laserstrahls eingestellt wird, so daß an beschichteten Bereichen der Fläche die Lackschicht abgebrannt und/oder verdampft wird und daß an unbeschichteten Bereichen der Fläche der Laserstrahl ohne wesentliche Beeinflussung der Siebdruckschablone reflektiert und/oder absorbiert wird.

2. Verfahren nach Anspruch 1,
dadurch **gekennzeichnet,**
daß die Siebdruckschablone vor dem Entfernen der Lackschicht vorbehandelt wird und insbesondere von Resten einer Druckfarbe unter Beibehaltung der Lackschicht gereinigt wird.

3. Verfahren nach Anspruch 1 oder 2,
dadurch **gekennzeichnet,**
daß zum Überstreichen der Fläche mit dem Laserstrahl eine Relativbewegung zwischen dem Laser und der Siebdruckschablone mit einer Vorschubgeschwindigkeit durchgeführt wird, welche beispielsweise 5 m/s bei einem 300 W-Laser betragen kann.

4. Verfahren nach einem der Ansprüche 1 bis 3,
dadurch **gekennzeichnet,**
daß bei Verwendung einer zylindrischen Siebdruckschablone diese zentrisch zu ihrer Zylinderachse eingespannt und um die Zylinderachse in Rotation versetzt wird,
daß der Laserstrahl im wesentlichen radial zur Zylinderachse auf die Siebdruckschablone ausgerichtet und aufgebracht wird und
daß eine gleichmäßige Relativbewegung parallel zur Zylinderachse zwischen dem Laser und der rotierenden Siebdruckschablone durchgeführt wird.

5. Verfahren nach einem der Ansprüche 1 bis 3,
dadurch **gekennzeichnet,**
daß bei Verwendung einer plattenförmigen Siebdruckschablone eine reversierende Linearbewegung relativ zwischen dem Laser und der Siebdruckschablone durchgeführt wird.

6. Verfahren nach einem der Ansprüche 1 bis 5,
dadurch **gekennzeichnet,**
daß eine Brennpunktsfläche des Laserstrahls auf der Siebdruckschablone möglichst groß eingestellt wird, insbesondere mit einem Durchmesser zwischen 0,1 mm und 5 mm, vorzugsweise 0,5 mm.

7. Vorrichtung zum Durchführen des Verfahrens nach einem der Ansprüche 1 bis 6,
dadurch **gekennzeichnet,**
- daß ein Dauerstrichlaser vorgesehen ist, welcher einen permanenten Laserstrahl erzeugt,
- daß eine Aufnahmeeinrichtung zum Einspannen einer Siebdruckschablone angeordnet ist,
- daß zum Überstreichen einer mit einer Lackschicht versehene Fläche der eingespannten Siebdruckschablone mit dem Laserstrahl eine Ablenkeinrichtung am Laser oder eine Bewegungseinrichtung für eine Relativbewegung zwischen dem Laser und der Aufnahmeeinrichtung angeordnet ist, und
- daß eine Steuereinrichtung zum Steuern der Ablenkeinrichtung oder der Bewegungseinrichtung vorgesehen ist, so daß der Laserstrahl die Fläche zeilenartig überstreicht.

8. Vorrichtung nach Anspruch 7,
dadurch **gekennzeichnet,**
daß der Dauerstrichlaser ein CO₂-Laser ist.

9. Vorrichtung nach Anspruch 7 oder 8,
dadurch **gekennzeichnet,**
daß die Bewegungseinrichtung einen Schlitten aufweist, der in mindestens einer Richtung bewegbar geführt ist, und
daß auf dem Schlitten der Laser angebracht ist.

10. Vorrichtung nach einem der Ansprüche 7 bis 9,
dadurch **gekennzeichnet,**
daß die Aufnahmeeinrichtung eine rotierend antreibbare Spindel sowie ein koaxial und versetzt dazu angeordnetes Spannelement aufweist und
daß das Spannelement auf einem Reitstock drehbar gelagert ist, der zum Spannen einer zylindrischen Siebdruckschablone axial zur Spindel verschiebbar ist.

11. Vorrichtung nach Anspruch 10,
dadurch **gekennzeichnet,**
daß zum Spannen zylindrischer Siebdruckschablonen unterschiedlicher Durchmesser die Spindel und das Spannelement im wesentlichen kegelförmig ausgebildet sind.
